# EUROPEAN PATENT SPECIFICATION

(11) **EP 0 381 592 B1**
(45) Date of publication and mention of the grant of the patent: **26.10.1994**
(21) Application number: 90400300.1
(22) Date of filing: 02.02.1990
(51) Int. Cl.: H05K 7/20

(54) **Concentrative control method of cooling a plurality of thermal loads**
Konzentriertes Regelungsverfahren für die Kühlung einer Vielzahl thermischer Belastungen
Méthode concentrée de contrôle de refroidissement des charges thermiques

(30) Priority: 03.02.1989 JP 23959/89
(43) Date of publication of application: 08.08.1990
(73) Proprietor: FUJITSU LIMITED, Kawasaki-shi, Kanagawa 211 (JP)
(72) Inventor: Okada, Tsuguo, Yokohama-shi, Kanagawa 227 (JP); Takemae, Motohiro, Fujisawa-shi, Kanagawa 252 (JP); Kawashima, Hisashi, Yokohama-shi, Kanagawa 227 (JP); Ohashi, Tadashi, Raionzumanshon Yamate 102, Yokohama-shi, Kanagawa 231 (JP)
(74) Representative: Joly, Jean-Jacques

(56) References cited:
- EP-A- 0 313 473
- FR-A- 2 580 060
- US-A- 3 774 677

## Description

### 1. Field of the Invention

The present invention relates to a concentrative control method of cooling a plurality of thermal loads, by a liquid-cooling process, in an electronic computer system having such a plurality of thermal loads.

### 2. Description of the Related Art

In a general liquid-cooling system for one thermal load, pumps circulate a cooled liquid e.g., water, to the thermal load through a heat exchanger, the water cools the thermal load, and the thus-warmed water is returned to a tank. A cooling control unit receives data of a temperature of the thermal load, a temperature of the water in the tank, and the like, and controls the heat exchanger to maintain the temperature of the thermal load substantially at an ambient temperature. The pumps, the tank and the like are generically known as a coolant distribution module. This liquid-cooling system, however, must be provided for each individual thermal load. Accordingly if the scale of the computing system is enlarged, a plurality of thermal loads exist therein, for example, a plurality of processors, a plurality of input and output channel units, magnetic memory devices, and the like, are treated as individual thermal loads, respectively, and thus the scale of the cooling system therefor becomes extremely large, and the cost-performance is very poor.

According to one prior art cooling system (US-A-3 774 677) based on a controlled spray of a coolant liquid from spray nozzles, there is provided a control arrangement in which the input signal to the controller for regulating the amount of coolant liquid supplied to the spray condensing nozzles is equipped with a temperature sensor which measures the temperature of the liquid return from the condenser, i.e. from a collective liquid tank.

In another related example disclosed in FR-A-2 580 060, a control is effected on the basis of a difference between the temperature of a coolant supplied into the system and the temperature of that coolant after it has been heated. The temperature difference serves as a basis to determine the number of heat exchangers to put into operation.

Other arts related to this invention are Japanese Unexamined Patent Publication (Kokai) No. 54-43478 and EP-A-0 313 473, (the latter falling under Art. 54 (3, EPC).

### SUMMARY OF THE INVENTION

An object of the present invention is to provide a concentrative control method of cooling a plurality of thermal loads as defined in claim 1.

Other features and advantages of the invention will be apparent from the following description given with reference to the accompanying drawings.

### BRIEF DESCRIPTION OF THE DRAWINGS

Figure 1 is a block diagram of a conventional cooling control system;
Fig. 2 is a block diagram of a cooling control system executing a concentrative control method of cooling a plurality of thermal loads according to an embodiment of this invention:
Fig. 3 is an explanatory diagram of heat exchanger modules in the system of Fig. 2;
Fig. 4 is a block diagram of a cooling control unit in the system of Fig. 2;
Fig. 5 is a graph explaining the relationship among thermal load temperatures, a temperature of collective liquid tank, and a target temperature;
Fig. 6 is a diagram explaining the relationship between an ambient temperature and a target temperature;
Fig. 7 is a diagram explaining a table related to the thermal loads.

### DESCRIPTION OF THE PREFERRED EMBODIMENTS

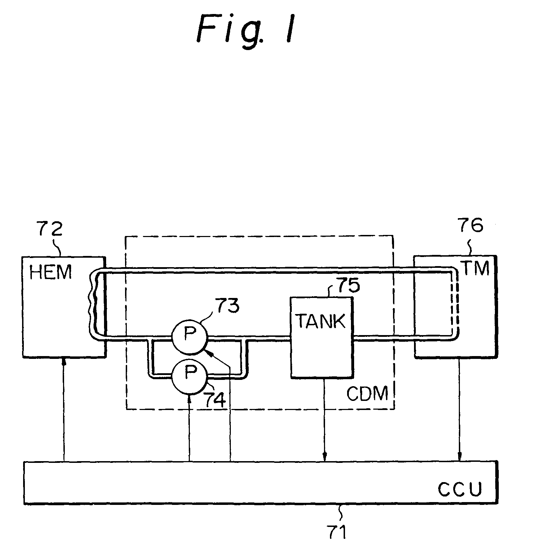

A constitution of a conventional cooling control system is first explained, for comparison with this invention, with reference to Fig. 1.

In the system, shown in Fig. 1, a pump (P) 73 or a pump (P) 74 pumps cooled liquid (or coolant), for example, water, to a thermal load (TM) 76 through a heat exchanger module (HEM) 72. The water cools the thermal load 76, and the thus-warmed water is returned to a tank 75. A cooling control unit (CCU) 71 receives data of a temperature of the thermal load 76, a temperature of the water in the tank 75, and the like, and controls the heat exchanger module 72 to maintain the temperature of the thermal load within a value substantially corresponding to an ambient temperature. Note, the elements enclosed by the broken line are collectively known as a coolant distribution module (CDM).

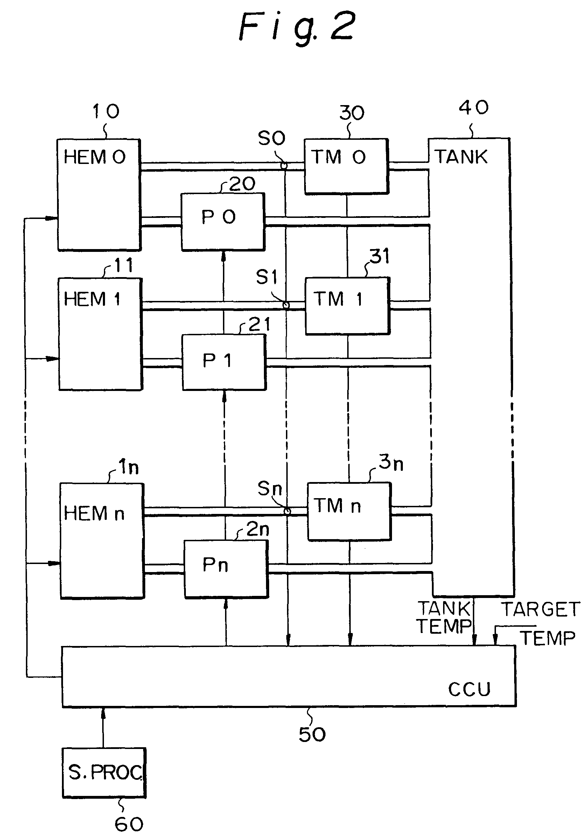

Figure 2 shows a block diagram of a cooling control system for executing a method according to this invention.

The system shown in Fig. 2 comprises (n + 1) number of heat exchanger modules (HEM0 - HEMn) 10 - 1n, (n + 1) number of pumps (P1 - Pn) 20 - 2n as a coolant distribution module, (n + 1) number of thermal loads (TM0 - TMn) 30 - 3n, a collective liquid tank (TANK) 40, a cooling control unit (CCU) 50, and a service processor (S.PROC.) 60. Tubes connect the coolant distribution module, the heat exchanger module and the thermal load, through which the coolant is circulated. After the coolant has flowed through the thermal load, the coolant enters the collective liquid tank 40 and then flows to the pump, and thereafter, the coolant from the collective liquid tank 40 is supplied to the heat exchanger module by the pump. Flow sensors S0 - Sn are provided in the tubes between the heat exchanger module and the thermal load, in correspondence to each thermal load.

The heat exchanger modules 10 - 1n and the pumps 20 - 2n are controlled by the cooling control unit 50. Namely the cooling control unit 50 receives signals from the flow sensors S0 - Sn indicating whether the flow quantity is normal or abnormal, the temperature data at the thermal loads 30 - 3n, the liquid temperature (TANK TEMP.) of the collective liquid tank 40, a predetermined target temperature, and instructions from the cooling control unit 50.

The operation of the system is explained hereunder. The pump supplies the coolant to the thermal loads through the heat exchanger module, circulates the coolant for the thermal loads which are, for example, printed boards of processors, memories, or the like, and the thus-warmed coolant is stored temporarily in the collective liquid tank 40. The temperature of the stored liquid is then measured, converted to an electric signal, and supplied to the cooling control unit 50. The coolant from the collective liquid tank 40 is pumped by the pump to the respective heat exchanger modules, and the cooled water is supplied to the thermal loads. The heat exchanger modules are controlled by the cooling control unit 50 so that the coolant temperature in the collective liquid tank 40 is equal to the target temperature.

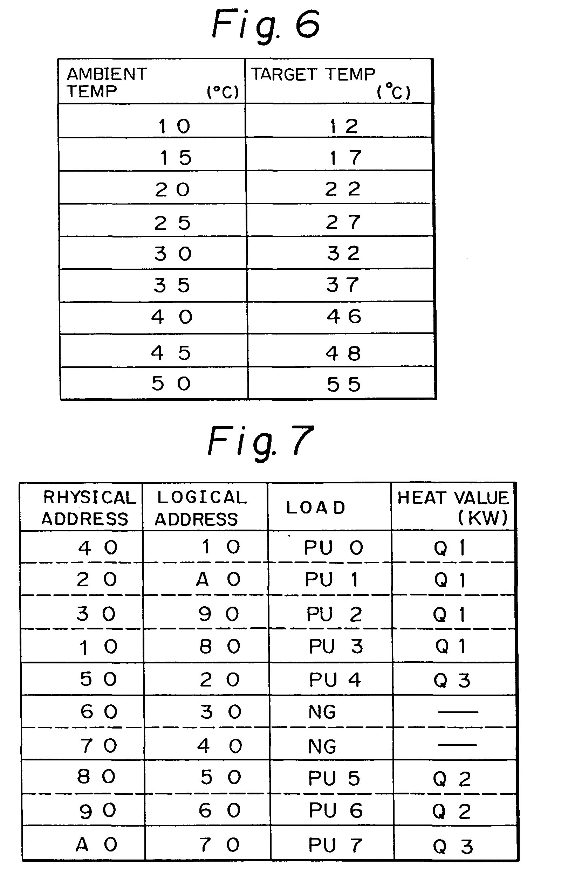

For example, the target temperature is determined as shown in Fig. 6, and corresponds to the ambient temperature. The cooling control unit 50 forms, for example, a table for the thermal loads, as shown in Fig. 7, using a service processor 60. Control variables for the heat exchanger modules corresponding to each target temperature shown in Fig. 6 are obtained from the above data in Fig. 7, by a computer simulation method and so on. In Fig. 7, the physical addresses and logical addresses of the cooling control unit expressed by hexadecimal notation, for example, A means 10. In the column LOAD in Fig. 7, PU0 to PU6 are processors, NG is not defined and PU7 is a memory device. In the column HEAT VALUE, Q1, Q2, and Q3 show heat power (kilowatt) generated from the load.

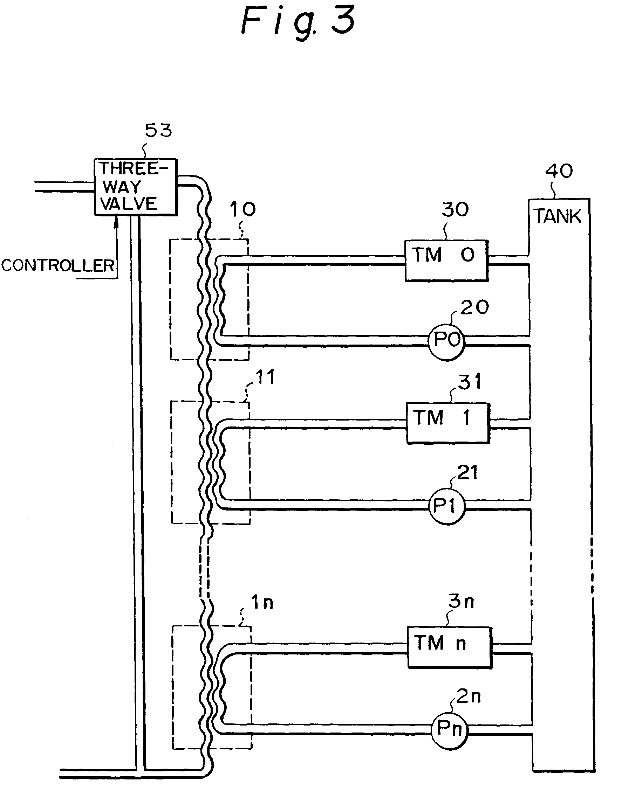

Figure 3 shows the detail of the heat exchanger module in Fig. 2, as an example. The heat exchanger modules are controlled by a three-way valve 53.

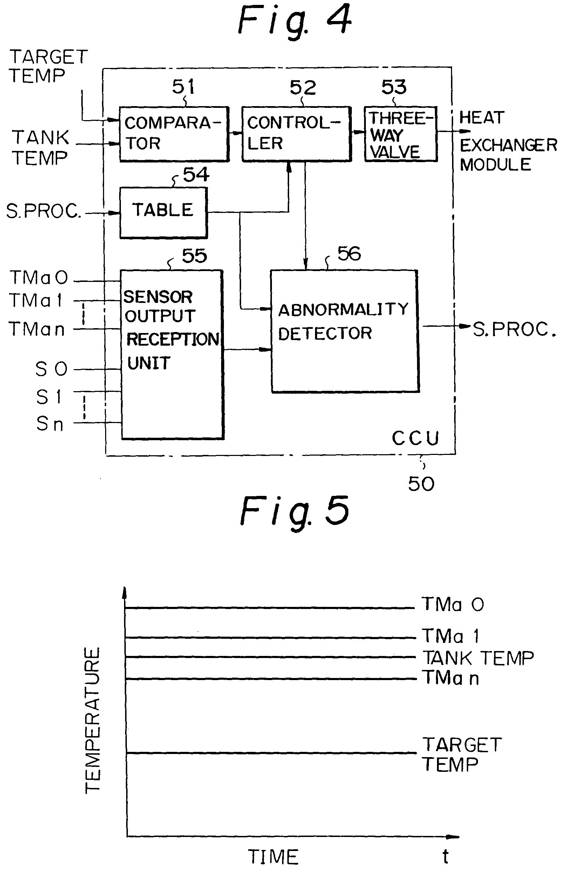

Figure 4 shows the detail of the cooling control unit 50. Namely, the temperature signal (TANK TEMP.) from the collective liquid tank 40 is compared with the predetermined target temperature signal by a comparator 51, the result of the comparison is supplied to a controller 52, the controller 52 operates the three-way valve 53 in accordance with the comparison result and the contents of the table in Fig. 7, and controls the heat exchanger modules through the three-way valve 53. The table 54 is formed by an instruction from the service processor 60, and the data of the table is supplied to the controller 52 and a abnormality detector 56. A sensor output reception unit 55 receives temperature signals from each of the thermal loads 30 - 3n, and outputs these signals to the abnormality detector 56. When a temperature signal shows an abnormal value, an alarm signal is output from the abnormality detector to the service processor 60. And outputs from the flow sensors S0 - Sn are supplied to the sensor output reception unit 55, and when an output is abnormal, the abnormality detector 56 detects the abnormal signal, and determines where in the system the abnormality is located.

Also, the output from the controller 52 is supplied to the abnormality detector 56. When the output of controller 52 is not within predetermined parameters, an abnormal control condition is detected by the abnormality detector 56.

Figure 5 is a graph explaining the relationship among the temperatures of the respective thermal loads (TMa0 - TMan), the temperature of the coolant in the collective liquid tank (TANK TEMP.), and the target temperature. The abscissa represents a time (t) and the ordinate temperature.

By using the above method, the average temperature of the coolant in the collective liquid tank, which temperature is obtained from the mix of the cooling liquid of the respective thermal loads, is detected and the heat exchanger modules are controlled so that the detected temperature is equal to the predetermined target temperature, instead of controlling the coolant temperature of each thermal load, respectively. Accordingly, a control using n number of loops is not necessary, and one loop feedback control is needed. Note, n is a number of thermal loads. Also, since the determination of the abnormal state is obtained by the operation of each flow sensor provided correspondingly to each thermal load, the cooling system is simplified.

## Claims

1. A concentrative control method of cooling plurality of thermal loads (30-3n) in a cooling control system comprising a plurality of thermal loads, a plurality of heat exchanger modules (10-1n), and a plurality of coolant distribution modules (P1-Pn) provided correspondingly for the plurality of thermal loads, a collective liquid tank (40) and a cooling control unit (50) for the plurality of thermal loads, said method comprising the steps of:
circulating cooling liquid from each of the coolant distribution modules to the collective liquid tank through each of the heat exchanger modules and each of the thermal loads, via each coolant distribution module,
comparing the temperature of the coolant liquid in the tank with a target temperature predetermined by the number and types of the thermal loads, and the ambient temperature, and
controlling each of the heat exchanger modules by the cooling control unit on the basis of said comparison step so as to make the temperature of cooling liquid in the tank equal to said target temperature.

2. A concentrative control method as set forth in claim 1, wherein said cooling control system further comprises flow sensors (20-2n) provided correspondingly at the input of each thermal load (30-3n) and connected to said cooling control unit (50), the method further comprising the step of detecting the flow condition of the cooling liquid at each thermal load (30-3n) and determining an abnormal state of the cooling control system if an output of any one of the flow sensors is abnormal.

3. A concentrative control method as set forth in claim 1, wherein
said target temperature is determined by a computer simulation using data of a number of thermal loads, types of thermal load, and the ambient temperature.

4. A concentrative control method as set forth in claim 1, wherein the heat exchangers are controlled by means of a three-way valve (53) in response to the compared data, and the contents of a table (Fig. 6) formed upon receipt of an instruction from a service processor (60).

## Patentansprüche

1. Konzentratives Steuerverfahren zum Kühlen von thermischen Belastungen (30 bis 3n) in einem Kühlsteuersystem mit einer Vielzahl von thermischen Belastungen, einer Vielzahl von Wärmetauschermodulen (10 bis 1n) und einer Vielzahl von Kühlmittel-Verteilungsmodulen (P1 bis Pn), die für die Vielzahl von thermischen Belastungen entsprechend vorgesehen sind, einem Flüssigkeitssammeltank (40) und einer Kühlsteuereinheit (50) für die Vielzahl von thermischen Belastungen, welches Verfahren die Schritte umfaßt:
Zirkulieren von Kühlflüssigkeit von jedem der Kühlmittel-Verteilungsmodule zum Flüssigkeitssammeltank durch jedes der Wärmetauschermodule und jede der thermischen Belastungen über jedes Kühlmittel-Verteilungsmodul,
Vergleichen der Temperatur der Kühlmittelflüssigkeit im Tank mit einer Zieltemperatur, die durch die Anzahl und Typen der thermischen Belastungen vorherbestimmt ist, und der Umgebungstemperatur, und
Steuern jedes der Wärmetauschermodule durch die Kühlsteuereinheit auf Basis des genannten Vergleichsschritts, um die Temperatur der Kühlflüssigkeit im Tank an die genannte Zieltemperatur anzugleichen.

2. Konzentratives Steuerverfahren nach Anspruch 1, wobei das genannte Kühlsteuersystem ferner Durchflußsensoren (20 bis 2n), die am Eingang jeder thermischen Belastung (30 bis 3n) entsprechend vorgesehen sind, und mit der genannten Kühlsteuereinheit (50) verbunden sind, umfaßt, welches Verfahren ferner den Schritt des Detektierens des Flußzustands der Kühlflüssigkeit an jeder thermischen Belastung (30 bis 3n) und des Bestimmens eines abnormalen Zustands des Kühlsteuersystems umfaßt, wenn ein Ausgang einer der Durchflußsensoren abnormal ist.

3. Konzentratives Steuerverfahren nach Anspruch 1, bei welchem die genannte Zieltemperatur durch eine Computersimulation unter Verwendung von Daten von einer Anzahl von thermischen Belastungen, Typen von thermischen Belastungen und der Umgebungstemperatur bestimmt wird.

4. Konzentratives Steuerverfahren nach Anspruch 1, bei welchem die Wärmetauscher mittels eines Dreiwegventils (53) ansprechend auf die verglichenen Daten und den Inhalt einer Tabelle (Fig.6), die beim Empfang einer Instruktion von einem Service-Prozessor (60) gebildet wird, gesteuert werden.

## Revendications

1. Procédé de commande concentré du refroidissement d'une pluralité de charges thermiques (3O-3n) dans un système de commande de refroidissement comprenant une pluralité de charges thermiques, une pluralité de modules échangeurs de chaleur (1O-1n) et une pluralité de modules de distribution de liquide réfrigérant (P1-Pn) prévus d'une manière correspondante pour la pluralité de charges thermiques, un réservoir de liquide collectif (40) et une unité de commande de refroidissement (50) pour la pluralité de charges thermiques, ledit procédé comprenant les étapes consistant à:
faire circuler le liquide réfrigérant de chacun des modules de distribution de liquide réfrigérant au réservoir de liquide collectif par l'intermédiaire de chacun des modules échangeurs de chaleur et de chacune des charges thermiques, par l'intermédiaire de chaque module de distribution de liquide réfrigérant,
comparer la température du liquide réfrigérant dans le réservoir à une température cible prédéterminée par le nombre et les types des charges thermiques, et la température ambiante, et
commander chacun des modules échangeurs de chaleur par l'unité de commande de refroidissement sur la base de ladite étape de comparaison de manière à rendre la température du liquide réfrigérant dans le réservoir égale à ladite température cible.

2. Procédé de commande concentré selon la revendication 1, dans lequel ledit système de commande de refroidissement comprend en outre des débitmètres (2O-2n) prévus d'une manière qui correspond à l'entrée de chaque charge thermique (3O-3n) et reliés à ladite unité de commande de refroidissement (50), le procédé comprenant en outre l'étape consistant à détecter l'état d'écoulement du liquide réfrigérant au niveau de chaque charge thermique (3O-3n) et à déterminer un état anormal du système de commande de refroidissement si une sortie de l'un quelconque des débitmètres est anormale.

3. Procédé de commande concentré selon la revendication 1, dans lequel ladite température cible est déterminée par une simulation informatique utilisant les données d'un certain nombre de charges thermiques, les types des charges thermiques et la température ambiante.

4. Procédé de commande concentré selon la revendication 1, dans lequel les échangeurs de chaleur sont commandés au moyen d'une vanne à trois voies (53) en réponse aux données comparées et au contenu d'un tableau (figure 6) formé lors de la réception d'une instruction provenant d'un processeur de service (60).
